# EUROPEAN PATENT APPLICATION

(11) **EP 4 273 928 A1**
(43) Date of publication of application: **08.11.2023**
(21) Application number: 22171175.7
(22) Date of filing: 02.05.2022
(51) Int. Cl.: H01L 25/16, H01L 23/373, H01L 23/433, H01L 23/492

(54) **A SEMICONDUCTOR PACKAGE COMPRISING POWER AND LOGIC ON A SINGLE CERAMIC PLATE**

(71) Applicant: Infineon Technologies AG, 85579 Neubiberg (DE)
(72) Inventor: ROTH, Alexander, 93197 Zeitlarn (DE)
(74) Representative: Lambsdorff & Lange Patentanwälte Partnerschaft mbB

(57) **Abstract**

A semiconductor package (10; 20; 30) comprising a ceramic plate 1, a first conductive layer (2) disposed on the ceramic plate 1, the first conductive layer (2) comprising a first portion (2.1) and a second portion (2.2), a semiconductor transistor die (3) disposed above the first portion (2.1) of the first conductive layer (2), an electrical connector (4) disposed between the semiconductor transistor die (3) and the first portion (2.1) of the first conductive layer (2), a semiconductor logic die (5) disposed on the second portion (2.2) of the first conductive layer (2), and an encapsulant (6) covering at least in part the ceramic plate (1), the first conductive layer (2), the semiconductor transistor die (3) and the semiconductor logic die (5).

## Description

### TECHNICAL FIELD

The present disclosure is related to a semiconductor package comprising a semiconductor transistor die and semiconductor logic die both being arranged on a common substrate.

### BACKGROUND

In many electronic systems it is necessary to employ voltage or current converters like AC/AC converters, AC/DC converters, DC/AC converters, DC/DC converters, or frequency converters in order to generate the currents, voltages and/or frequencies to be used by an electronic circuit like, for example, a motor driving circuit. The converter circuits as mentioned before typically comprise one or more half-bridge circuits, each provided by two semiconductor power switches, such as e.g. power MOSFET devices, in particular insulated gate bipolar transistor (IGBT) devices, and further components such as diodes connected in parallel to the transistor devices, and passive devices such as resistors, inductors, and capacitors.

The switching of the power MOSFET devices can be controlled by one or more semiconductor logic devices, namely driver devices. The assembly of the aforementioned devices can in principle be accomplished by mounting and interconnecting the devices as individual components on a printed circuit board (PCB). There is, however, a general tendency to provide integrated semiconductor modules having short interconnections between the devices in order to reduce switching losses and parasitic inductances. Such integrated semiconductor package modules are also called integrated power modules (IPMs).

However, such a combination of logic and power devices in one module encounters difficulties as the requirements on the substrates are conflicting. The logic device requires comparatively thin conductors, while the power device requires rather thick metal to provide sufficient current carrying capacity.

For these and other reasons there is a need for the present disclosure.

### SUMMARY

An aspect of the present disclosure is related to a semiconductor package comprising a semiconductor package comprising a ceramic plate, a first conductive layer disposed on the ceramic plate, the first conductive layer comprising a first portion and a second portion, a semiconductor transistor die disposed above the first portion of the first conductive layer, an electrical connector disposed between the semiconductor transistor die and the first portion of the first conductive layer, a semiconductor logic die disposed on the second portion of the first conductive layer, and an encapsulant covering at least in part the ceramic plate, the first conductive layer, the semiconductor transistor die and the semiconductor logic die.

### BRIEF DESCRIPTION OF THE DRAWINGS

The accompanying drawings are included to provide a further understanding of embodiments and are incorporated in and constitute a part of this specification. The drawings illustrate embodiments and together with the description serve to explain principles of embodiments. Other embodiments and many of the intended advantages of embodiments will be readily appreciated as they become better understood by reference to the following detailed description.

The elements of the drawings are not necessarily to scale relative to each other. Like reference numerals designate corresponding similar parts.
Fig. 1 shows a cross-sectional side view on an example of a semiconductor package comprising a ceramic plate, a first conductive layer, a semiconductor transistor die, an electrical connector, a semiconductor logic die, and an encapsulant.
Fig. 2 shows a down view on an example of a semiconductor package showing further details like external leads and their electrical connections to the semiconductor dies.
Fig. 3 shows a cross-sectional side view on an example of a semiconductor package similar to the one of Fig. 1 with an additional plated layer on the first conductive layer and the electrical connector.

### DESCRIPTION OF EMBODIMENTS

In the following detailed description, reference is made to the accompanying drawings, which form a part hereof, and in which is shown by way of illustration specific embodiments in which the disclosure may be practiced. In this regard, directional terminology, such as "top", "bottom", "front", "back", "leading", "trailing", etc., is used with reference to the orientation of the Figure(s) being described. Because components of embodiments can be positioned in a number of different orientations, the directional terminology is used for purposes of illustration and is in no way limiting. It is to be understood that other embodiments may be utilized and structural or logical changes may be made without departing from the scope of the present disclosure. The following detailed description, therefore, is not to be taken in a limiting sense, and the scope of the present disclosure is defined by the appended claims.

It is to be understood that the features of the various exemplary embodiments described herein may be combined with each other, unless specifically noted otherwise.

As employed in this specification, the terms "bonded", "attached", "connected", "coupled" and/or "electrically connected/electrically coupled" are not meant to mean that the elements or layers must directly be contacted together; intervening elements or layers may be provided between the "bonded", "attached", "connected", "coupled" and/or "electrically connected/electrically coupled" elements, respectively. However, in accordance with the disclosure, the above-mentioned terms may, optionally, also have the specific meaning that the elements or layers are directly contacted together, i.e. that no intervening elements or layers are provided between the "bonded", "attached", "connected", "coupled" and/or "electrically connected/electrically coupled" elements, respectively.

Further, the word "over" used with regard to a part, element or material layer formed or located "over" a surface may be used herein to mean that the part, element or material layer be located (e.g. placed, formed, deposited, etc.) "indirectly on" the implied surface with one or more additional parts, elements or layers being arranged between the implied surface and the part, element or material layer. However, the word "over" used with regard to a part, element or material layer formed or located "over" a surface may, optionally, also have the specific meaning that the part, element or material layer be located (e.g. placed, formed, deposited, etc.) "directly on", e.g. in direct contact with, the implied surface.

Moreover, the word "exemplary" is used herein to mean serving as an example, instance, or illustration. Any aspect or design described herein as "exemplary" is not necessarily to be construed as advantageous over other aspects or designs. Rather, use of the word exemplary is intended to present concepts in a concrete fashion. As used in this application, the term "or" is intended to mean an inclusive "or" rather than an exclusive "or". That is, unless specified otherwise, or clear from context, "X employs A or B" is intended to mean any of the natural inclusive permutations. That is, if X employs A; X employs B; or X employs both A and B, then "X employs A or B" is satisfied under any of the foregoing instances. In addition, the articles "a" and "an" as used in this application and the appended claims may generally be construed to mean "one or multiple" unless specified otherwise or clear from context to be directed to a singular form. Also, at least one of A and B or the like generally means A or B or both A and B.

In addition, while a particular feature or aspect of an embodiment of the disclosure may have been disclosed with respect to only one of several implementations, such feature or aspect may be combined with one or more other features or aspects of the other implementations as may be desired and advantageous for any given or particular application. Furthermore, to the extent that the terms "include", "have", "with", or other variants thereof are used in either the detailed description or the claims, such terms are intended to be inclusive in a manner similar to the term "comprise". Furthermore, it should be understood that embodiments of the disclosure may be implemented in discrete circuits, partially integrated circuits or fully integrated circuits or programming means. Also, the term "exemplary" is merely meant as an example, rather than the best or optimal. It is also to be appreciated that features and/or elements depicted herein are illustrated with particular dimensions relative to one another for purposes of simplicity and ease of understanding, and that actual dimensions may differ substantially from that illustrated herein.

### DETAILED DESCRIPTION

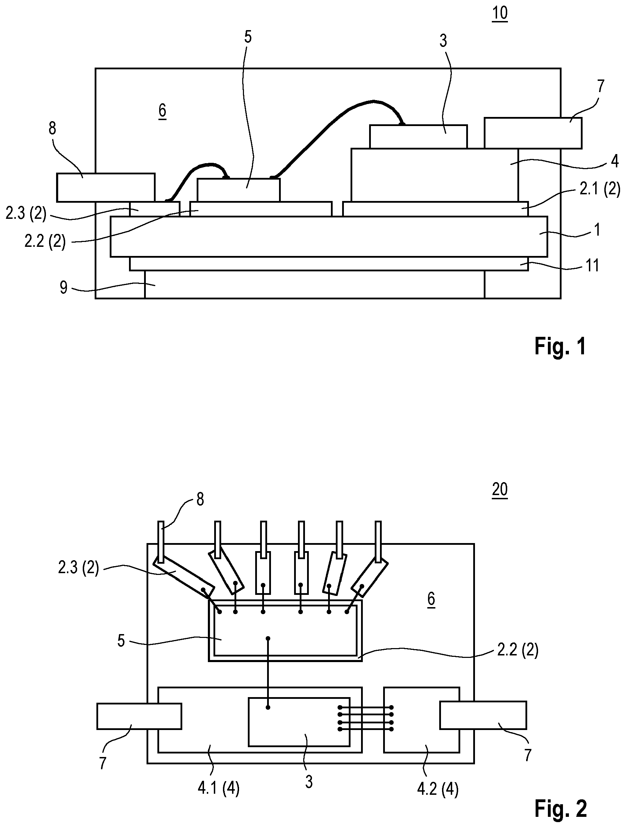

Fig. 1 shows a cross-sectional side view on an example of a semiconductor package comprising a ceramic plate, a first conductive layer or film, a semiconductor transistor die, an electrical connector, a semiconductor logic die, and an encapsulant.

More specifically, Fig. 1 shows a semiconductor package 10 comprises a semiconductor package 10, comprising a ceramic plate 1, a first conductive layer 2 disposed on the ceramic plate 1, the first conductive layer 2 comprising a first portion 2.1 and a second portion 2.2, a semiconductor transistor die 3 disposed above the first portion 2.1 of the first conductive layer 2, an electrical connector 4 disposed between the semiconductor transistor die 3 and the first portion 2.1 of the first conductive layer 2, a semiconductor logic die 5 disposed on the second portion 2.2 of the first conductive layer 2, and an encapsulant 6 covering at least in part the ceramic plate 1, the first conductive layer 2, the semiconductor transistor die 3 and the semiconductor logic die 5.

According to the embodiment of Fig. 1, the ceramic plate 1 is optionally disposed on a metallic substrate 9 which can be made of copper, aluminum or any composite of those metals. A thickness of the metallic substrate 9 can be in a range from 200 µm to 500 µm. Furthermore a second conductive layer 11 can be disposed between the ceramic plate 1 and the metallic substrate 9. The second conductive layer 11 may have the same or similar properties as the first conductive layer 2.

Also shown in the embodiment of Fig. 1 are two bond wires, one being connected between a contact pad of the logic semiconductor die 5 and a gate pad of the power semiconductor die 3, and the other one being connected between another contact pad of the logic semiconductor die 5 and one of a plurality of third portions 2.3 of the first conductive layer 2.

Also shown in the embodiment of Fig. 1 is one of first external pins 7 connected with the semiconductor transistor die 3, and one of second external pins 8 connected with the logic semiconductor die 5. The first external pins 7 are connected with different portions of the electrical conductor 4, and the second external pins are connected with the third portions 2.3 of the first conductive layer 2.

In the semiconductor package 10 the semiconductor transistor die 3 can in particular be a power semiconductor transistor die 3. Here, the term "power semiconductor transistor die" may refer to a semiconductor die providing at least one of high voltage blocking or high current-carrying capabilities. A power semiconductor die may be configured for high currents having a maximum current value of a few Amperes, such as e.g. 10 A, or a maximum current value of up to or exceeding 100 A. Similarly, voltages associated with such current values may have values of a few Volts to a few tens or hundreds or even thousands of Volts.

In general, semiconductor dies 3 as described herein may be manufactured from an elemental semiconductor material (e.g. Si) or from a wide band gap semiconductor material or a compound semiconductor material (e.g. SiC, GaN, SiGe, GaAs) .

According to an embodiment of the semiconductor package 10, the ceramic plate 1 comprises one of Al₂O₃, AlN, Si₃N₄, or zirconia toughened alumina (ZTA), BeO, SiC, AlON, ZrO, or any other ceramic according to DIN V ENV 12212.

According to an embodiment of the semiconductor package 10, the ceramic plate 1 comprises a thickness greater than 500 µm or greater than 600 µm or greater than 635 µm.

According to an embodiment of the semiconductor package 10, the first conductive layer 2 comprises an International Annealed Copper Standard (IACS) >30%. IACS is an empirically derived standard value for the electrical conductivity of commercially available copper. According to an example thereof, the first conductive layer 2 comprises a copper basis with a share of >50%.

In the following, the first conductive layer 2 is described in more detail. The first conductive layer 2 is primarily a thick film paste and may comprise copper as a metal and optionally Bi₂O₃.

The thick-film paste of the first conductive layer 2 comprises preferably 40 to 92 wt.-% copper, more preferably 40 to less than 92 wt.-% copper, more preferably 70 to less than 92 wt.-% copper, most preferably 75 to 90 wt.-% copper, each based on the total weight of the thick-film paste. Furthermore the thick-film paste comprises preferably 0 to 50 wt.-% Bi₂O₃, more preferably 1 to 20 wt.-% Bi₂O₃, most preferably 2 to 15 wt.-% Bi₂O₃, each based on the total weight of the thick-film paste.

The copper particles used in the thick-film paste of the first conductive layer 2 have a median diameter (d₅₀) preferably of between 0.1 to 20 µm, more preferably of between 1 and 10 µm, most preferably of between 2 and 7 µm. The Bi₂O₃ particles used optionally in the thick-film paste have a median diameter (d₅₀) preferably of less than 100 µm, more preferably of less than 20 µm, most preferably of less than 10 µm.

According to a further embodiment of the present disclosure, the metal-containing thick-film paste of the first conductive layer 2 may comprise copper and a glass component. The amount of copper in the thick-film paste in case of a simultaneous use of a glass component might be as defined above, i.e. preferably in an amount of from 40 to 92 wt.-%, more preferably 40 to less than 92 wt.-% copper, more preferably in an amount of from 70 to less than 92 wt.-% copper, most preferably in an amount of from 75 to 90 wt.-% copper, each based on the total weight of the thick-film paste.

In the case of use of a glass component in the thick-film paste of the first conductive layer 2, the thick-film paste comprises preferably of from 0 to 50 wt.-%, more preferably 1 to 20 wt.-%, most preferably 2 to 15 wt.-%, of the glass component, each based on the total weight of the thick-film paste.

In the case of use of a glass component in the thick-film paste of the first conductive layer 2, the copper particles may have the same median diameter (d₅₀) as already mentioned above, *i*.*e*. preferably of between 0.1 to 20 µm, more preferably of between 1 and 10 µm, most preferably of between 2 and 7 µm.

In the case of use of a glass component in the thick-film paste, the glass component particles may have a median diameter (d₅₀) of less than 100 µm, more preferably less than 20 µm, most preferably less than 10 µm.

The metal-containing thick-film paste, preferably on the basis of copper, may comprise - besides the glass component and Bi₂O₃ - further components, selected from the group consisting of PbO, TeO2, Bi₂O₃, ZnO, B₂O₃, Al₂O₃, TiO₂, CaO, K₂O, MgO, Na₂O, ZrO₂, and Li₂O.

According to an embodiment of the present disclosure, the amount of copper oxide in the thick-film paste of the first conductive layer 2 is less than 2 wt.-%, more preferably less than 1.9 wt.-%, more preferably less than 1.8 wt.-%, more preferably less than 1.5 wt.-%.

Alternative embodiments of the first conductive layer 2 may be comprised out of commonly known active metal brazing alloys, e.g. Ag66Cu29.5Ti1.5.

According to an embodiment of the present disclosure, the layer thickness of the first conductive layer 2 is preferably of from 5 to 150 µm, more preferably of from 20 to 125 µm, most preferably of from 30 to 100 µm.

According to an embodiment of the present disclosure, the electrical connector 4 comprises an International Annealed Copper Standard >70%. According to an example thereof, the electrical connector 4 comprises one of OF-Copper or tough pitch copper (TPC).

According to an embodiment of the present disclosure, the electrical connector 4 comprises a thickness greater than 125 µm or greater than 300 µm.

The encapsulant 6 may be comprised of a conventional mold compound like, for example, a resin material, in particular an epoxy resin material. Moreover, the encapsulant 6 can be made of a thermally conductive material to allow efficient heat dissipation to external application heat sinks. The material of the encapsulant 15 can, in particular, comprise a resin like an epoxy resin material filled with particles like, for example, SiO or other ceramic particles, or thermally conductive particles like, for examples, Al₂O₃, BN, AlN, Si₃N₄, diamond, or any other thermally conductive particles.

According to an embodiment of the present disclosure, two or more semiconductor transistor dies, in particular power transistor dies, may be provided in the semiconductor package, which transistor dies may be connected to a driving logic die in the same way as the semiconductor die 3. In the present case, the power semiconductor dies may particularly be used in half bridge configurations and/or boost configurations, such as e.g. buck-boost-converters or boost converters. The configurations may be used for industrial grade products applied in one or more of integrated servo motor inverters or PFC (Power Factor Correction) Boost stages, for example. Addressed applications may include automotive applications, industrial drive applications, EV (Electric Vehicle) charging, etc.

Fig. 2 shows a down view on an example of a semiconductor package showing further details like external leads and their electrical connections to the semiconductor dies.

More specifically, Fig. 2 depicts a semiconductor device package 20 which is similar to the semiconductor device package 10 of Fig. 1 so that most of the reference signs of Fig. 1 were adopted and with regard to the function of the corresponding elements, reference is made to the above description.

In addition to the embodiment of a semiconductor package 10 as shown in Fig. 1, the semiconductor package 20 shows a plurality of second external pins 8 which are connected with the logic semiconductor die 5. The semiconductor package 20 furthermore shows a plurality of third portions 2.3 of the first conductive layer 2 and a particular arrangement of these third portions 2.3. The logic semiconductor die 5 has a plurality of contact pads on its upper surface. Each one of the third portions 2.3 of the first conductive layer 2 is connected at its outer end to one of the second external pins 8 and connected at its inner end to one of the contact pads of the logic semiconductor die 5 by means of a bonding wire.

A width of each one of the third portions 2.3 of the first conductive layer 2 can be below 500 µm or below 250 µm and a pitch between adjacent third portions 2.3 can be below 1 mm or below 500 µm.

The electrical conductor 4 comprises two portions 4.1 and 4.2. The semiconductor transistor die 3 is attached to an upper surface of a first portion 4.1 of the electrical conductor 4 which first portion 4.1 is connected by bond wires or clips to a second portion 4.2 of the electrical conductor 4. One of the first external leads 7 is connected to the first portion 4.1, and another one of the first external leads 7 is connected with the second portion 4.2.

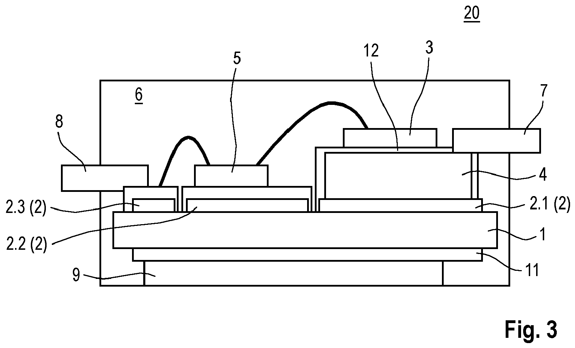

Fig. 3 shows a cross-sectional side view on an example of a semiconductor package similar to the one of Fig. 1 with an additional plated layer on the first conductive layer and the electrical connector.

More specifically, Fig. 3 depicts a semiconductor device package 20 which is similar to the semiconductor device package 10 of Fig. 1 so that most of the reference signs of Fig. 1 were adopted and with regard to the function of the corresponding elements, reference is made to the above description.

An amendment as compared to Fig. 1 is that the semiconductor package 20 of Fig. 3 comprises an additional layer 12 of electroless plating or an electroplating of copper, nickel, gold, silver or any layer stack thereof to provide an improved electrical conductivity and/or compatibility to common interconnect technologies. A further such layer can also be applied to the metallic substrate 9.

### EXAMPLES

In the following specific examples of the present disclosure are described.

Example 1 is a semiconductor package, comprising a ceramic plate, a first conductive layer disposed on the ceramic plate, the first conductive layer comprising a first portion and a second portion, a semiconductor transistor die disposed above the first portion of the first conductive layer, an electrical connector disposed between the semiconductor transistor die and the first portion of the first conductive layer, a semiconductor logic die disposed on the second portion of the first conductive layer, and an encapsulant covering at least in part the ceramic plate, the first conductive layer, the semiconductor transistor die and the semiconductor logic die.

Example 2 is the semiconductor package according to Example 1, wherein the ceramic plate comprises one of Al2O3, AlN, Si3N4, or zirconia toughened alumina, BeO, SiC, or any other ceramic according to DIN V ENV 12212.

Example 3 is the semiconductor package according to Example 1 or 2, wherein the ceramic plate comprises a thickness greater than 500 µm or greater than 600 µm or greater than 635 µm.

Example 4 is the semiconductor package according to any one of the preceding Examples, wherein the first conductive layer comprises an electrical conductivity of >30% according to the International Annealed Copper Standard.

Example 5 is the semiconductor package according to Example 4, wherein the first conductive layer comprises a copper basis with a share of >50%.

Example 6 is the semiconductor package according to any one of the preceding Examples, wherein a thickness of the first conductive layer is in a range from 5 to 150 µm, or from 20 to 125 µm, or from 30 to 100 µm.

Example 7 is the semiconductor package according to any one of the preceding Examples, wherein the electrical connector comprises an electrical conductivity of >70% according to the International Annealed Copper Standard.

Example 8 is the semiconductor package according to any one of the preceding Examples, wherein the electrical connector comprises one of OF-Copper or tough pitch copper.

Example 9 is the semiconductor package according to any one of the preceding Examples, wherein the electrical connector comprises a thickness greater than 125 µm or greater than 300 µm.

Example 10 is the semiconductor package according to any one of the preceding Examples, further comprising a plurality of pins, wherein first pins of the plurality of pins are connected with the semiconductor transistor die, and second pins of the plurality of pins are connected with the semiconductor logic die.

Example 11 is the semiconductor package according to any one of the preceding Examples, wherein the first conductive layer comprises a plurality of third portions disposed on the ceramic plate, each one of the third portions connected with one of the second pins.

Example 12 is the semiconductor package according to any one of the preceding Examples, wherein the ceramic plate is disposed on a metallic substrate.

Example 13 is the semiconductor package according to Example 12, wherein a second conductive layer is disposed between the ceramic plate and the metallic substrate.

Example 14 is the semiconductor package according to any one of the preceding Examples, further comprising a further conductive layer covering the first conductive layer and the electrical connector.

Example 15 is the semiconductor package according to Example 14, wherein the further conductive layer is a plated layer.

Example 16 is the semiconductor package according to Example 15, wherein the plated layer is an electroless plating of copper, nickel, gold, silver or any layer stack thereof.

Example 17 is the semiconductor package according to any one of the preceding Examples, wherein the semiconductor transistor die is a power semiconductor transistor die.

Although specific embodiments have been illustrated and described herein, it will be appreciated by those of ordinary skill in the art that a variety of alternate and/or equivalent implementations may be substituted for the specific embodiments shown and described without departing from the scope of the present disclosure. This application is intended to cover any adaptations or variations of the specific embodiments discussed herein. Therefore, it is intended that this disclosure be limited only by the claims and the equivalents thereof.

## Claims

1. A semiconductor package (10; 20; 30), comprising
a ceramic plate (1);
a first conductive layer (2) disposed on the ceramic plate (1), the first conductive layer (2) comprising a first portion (2.1) and a second portion (2.2);
a semiconductor transistor die (3) disposed above the first portion (2.1) of the first conductive layer (2);
an electrical connector (4) disposed between the semiconductor transistor die (3) and the first portion (2.1) of the first conductive layer (2);
a semiconductor logic die (5) disposed on the second portion (2.2) of the first conductive layer (2); and
an encapsulant (6) covering at least in part the ceramic plate (1), the first conductive layer (2), the semiconductor transistor die (3) and the semiconductor logic die (5).

2. The semiconductor package (10; 20; 30) according to claim 1, wherein
the ceramic plate (1) comprises one of Al2O3, AlN, Si3N4, or zirconia toughened alumina, BeO, SiC, or any other ceramic according to DIN V ENV 12212.

3. The semiconductor package (10; 20; 30) according to claim 1 or 2, wherein
the ceramic plate (1) comprises a thickness greater than 500 µm or greater than 600 µm or greater than 635 µm.

4. The semiconductor package (10; 20; 30) according to any one of the preceding claims, wherein
the first conductive layer (2) comprises an electrical conductivity of >30% according to the International Annealed Copper Standard.

5. The semiconductor package (10; 20; 30) according to claim 4, wherein
the first conductive layer (2) comprises a copper basis with a share of >50%.

6. The semiconductor package (10; 20; 30) according to any one of the preceding claims, wherein a thickness of the first conductive layer (2) is in a range from 5 to 150 µm, or from 20 to 125 µm, or from 30 to 100 µm.

7. The semiconductor package (10; 20; 30) according to any one of the preceding claims, wherein
the electrical connector (4) comprises an electrical conductivity of >70% according to the International Annealed Copper Standard.

8. The semiconductor package (10; 20; 30) according to any one of the preceding claims, wherein
the electrical connector (4) comprises one of OF-Copper or tough pitch copper.

9. The semiconductor package (10; 20; 30) according to any one of the preceding claims, wherein
the electrical connector (4) comprises a thickness greater than 125 µm or greater than 300 µm.

10. The semiconductor package (10; 20; 30) according to any one of the preceding claims, further comprising a plurality of pins (7, 8), wherein
first pins (7) of the plurality of pins (7, 8) are connected with the semiconductor transistor die (3), and
second pins (8) of the plurality of pins (7, 8) are connected with the semiconductor logic die (5).

11. The semiconductor package (10; 20; 30) according to any one of the preceding claims, wherein
the first conductive layer (2) comprises a plurality of third portions (2.3) disposed on the ceramic plate (1), each one of the third portions (2.3) connected with one of the second pins (7).

12. The semiconductor package (10; 20; 30) according to any one of the preceding claims, wherein
the ceramic plate (1) is disposed on a metallic substrate (9) .

13. The semiconductor package (10; 20; 30) according to claim 12, wherein
a second conductive layer (11) is disposed between the ceramic plate (1) and the metallic substrate (9).

14. The semiconductor package (30) according to any one of the preceding claims, further comprising
a further conductive layer (12) covering the first conductive layer (2) and the electrical connector (4).

15. The semiconductor package (30) according to claim 14, wherein
the further conductive layer (12) is a plated layer (12).

16. The semiconductor package (30) according to claim 15, wherein the plated layer (12) is an electroless plating of copper, nickel, gold, silver or any layer stack thereof.

17. The semiconductor package (10; 20; 30) according to any one of the preceding claims, wherein
the semiconductor transistor die (3) is a power semiconductor transistor die (3).
